# FASCICULE DE BREVET EUROPEEN

(11) **EP 3 929 970 B1**
(45) Date de publication et mention de la délivrance du brevet: **01.03.2023**
(21) Numéro de dépôt: 21181113.8
(22) Date de dépôt: 23.06.2021
(51) Int. Cl.: H01L 21/683, H01L 21/60, H01L 21/67

(54) **PROCÉDÉ DE TRANSFERT DE PUCES**
CHIP-ÜBERTRAGUNGSVERFAHREN
CHIP TRANSFER METHOD

(30) Priorité: 25.06.2020 FR 2006667
(43) Date de publication de la demande: 29.12.2021
(73) Titulaire: Commissariat à l'Énergie Atomique et aux Énergies Alternatives, 75015 Paris (FR)
(72) Inventeur: FOURNEL, Frank, 38054 Grenoble (FR); BOURJOT, Emilie, 38054 Grenoble (FR); CHERAMY, Séverine, 38054 Grenoble (FR); MAITREJEAN, Sylvain, 38054 Grenoble (FR); SANCHEZ, Loïc, 38054 Grenoble (FR)
(74) Mandataire: Hautier IP

(56) Documents cités:
- US-A1- 2019 252 221
- US-A1- 2019 252 350

## Description

### DOMAINE TECHNIQUE

La présente invention concerne le domaine des puces utilisées en microélectronique. Par dispositif microélectronique, on entend tout type de dispositif réalisé avec les moyens de la microélectronique. Ces dispositifs englobent des dispositifs micro-mécaniques ou électromécaniques (MEMS, NEMS...).

Elle trouve une application dans tous les secteurs dans lesquels des puces sont utilisées. Par exemple, ces puces peuvent être destinées à une intégration sur des supports eux-mêmes implantés dans des dispositifs microélectroniques, tels des imageurs, ou d'autres dispositifs mettant en oeuvre des circuits intégrés, comme ceux liés à l'intégration 3D avec empilements de transistors CMOS et/ou de mémoires.

### ETAT DE LA TECHNIQUE

L'implémentation de puces dans des dispositifs microélectroniques conduit à des manipulations des puces d'une part avec une partie de process liée à leur fabrication proprement dite, généralement sur un premier support, et d'autre part avec une partie de process liée au transfert des puces dans les dispositifs, c'est-à-dire que les puces sont transférées vers un autre support.

Historiquement, les puces étaient souvent transférées les unes après les autres, par des outils de manipulation individuelle.

Des technologies de transfert collectif de telles puces, ont plus récemment été proposées, par exemple dans la publication scientifique « A. Jouve, in 2019 IEEE 69th Electronic Components and Technology Conférence (ECTC) (2019), pp. 225-234 ». Suivant ce document, sur la base d'un substrat de départ, les puces sont d'abord singularisées, puis transférées une par une sur un support temporaire pour y subir une préparation (par exemple un nettoyage suite à l'étape mécanique de singularisation). Ensuite, les puces sont reportées sur un substrat de destination. Pour ce report, cette technologie a l'avantage d'autoriser un collage direct des puces, éventuellement en mettant en oeuvre une technologie d'auto alignement de la puce relativement à la zone du substrat de destination qui lui est attribuée, grâce à la formation de gouttes d'eau entre chaque puce et le substrat de report, permettant d'accommoder des décalages de position.

La technologie permettant les transferts de puces selon cette publication scientifique est cependant perfectible, surtout dans un contexte d'accroissement des cadences de production, la technique proposée ne permettant pas un report collectif complet des puces. Or, la manipulation individuelle de puces souffre de limitations technologiques liées, par exemple, à leur résolution insuffisante relativement aux dimensions de plus en plus réduites des puces.

Dans d'autres cas, même si la taille des puces autorise encore leur préhension individuelle, par la tête d'un outil de placement de composants (souvent appelé système « pick and place » pour « collecte et placement»), on rencontre des limitations dimensionnelles importantes lorsqu'il s'agit de disposer individuellement ces puces sur un même support.

Par exemple, quand il s'agit de maintenir les puces sur un support, tels que ceux du type poignée, par exemple pour certaines étapes technologiques comme des nettoyages ou des activations de surface, les supports actuels portent nécessairement les puces de façon éloignée les unes des autres, car les cavités qui les reçoivent sont séparées par des parois qui doivent être suffisamment épaisses pour des raisons de résistance mécanique. En pratique, un espace de l'ordre de 500 µm est généralement induit entre chaque puce sur de tels supports.

US 2019/252350 A1 divulgue un procédé de transfert selon le préambule de la revendication 1.

Un objet de la présente invention est de proposer une solution à tout ou partie des inconvénients des techniques actuelles. Notamment, elle propose une solution au report d'une ou plusieurs puces depuis un premier support vers un deuxième support, de manière améliorée.

Les autres objets, caractéristiques et avantages de la présente invention apparaîtront à l'examen de la description suivante et des dessins d'accompagnement. Il est entendu que d'autres avantages peuvent être incorporés.

### RESUME

L'invention fournit un procédé de transfert tel que défini dans la revendication 1.

Selon un mode de réalisation, on prévoit un procédé de transfert d'au moins une puce, depuis un premier support vers un deuxième support, comprenant :
- alors que la puce est solidaire du premier support, une formation d'une couche intercalaire à l'état liquide entre, et au contact de, une face avant de la puce et une surface d'assemblage d'une face du deuxième support, et une solidification de la couche intercalaire ;
- puis, une désolidarisation de la puce relativement au premier support tout en maintenant la couche intercalaire à l'état solide.

On détourne ainsi la technique du dépôt de goutte d'eau, habituellement employée dans un contexte d'ajustement de position relative de deux parties à assembler par collage direct. Ici, le liquide, qui peut encore être de l'eau, a pour fonction d'opérer une fixation plus solide entre le deuxième support et la puce.

Suivant un aspect, la désolidarisation peut comprendre un déplacement relatif du premier support et du deuxième support.

Suivant un aspect non limitatif, la désolidarisation comprend un déplacement relatif du premier support et du deuxième support configuré pour rompre une liaison mécanique entre le premier support et la puce. La fixation fournie par la couche intercalaire est alors choisie suffisante pour vaincre la force de liaison, telle un ancrage, entre le premier support et la puce.

Suivant un autre aspect non limitatif, la désolidarisation comprend la désactivation d'un système de rétention de la puce sur le premier support, par exemple la coupure d'un système de mise en dépression ou encore l'ouverture d'une pince.

La couche intercalaire étant réalisée à l'état liquide, sa formation est aisée, par exemple sous forme de goutte. Elle peut être localisée précisément si besoin. Une approche du deuxième support auparavant placé à une basse température (suffisamment basse pour solidifier la couche intercalaire) peut permettre de solidifier la couche intercalaire de manière quasi instantanée lorsque sa face accoste la couche jusqu'alors liquide.

Suivant un aspect, la couche intercalaire est supprimée après le transfert. Làencore, l'emploi d'une couche intercalaire d'abord liquide permet cette suppression, par exemple par simple évaporation. On peut alors notamment parvenir directement à un collage direct de la face avant de la puce sur la surface d'assemblage du deuxième support.

Suivant un aspect, mais non limitativement, ce report est opéré de manière collective, c'est-à-dire pour plusieurs puces en même temps. Cela évite le recours systématique à des outils de manipulation individuelle des puces.

Suivant un autre aspect, le report s'effectue individuellement, pour une ou plusieurs puces. On peut alors par exemple maintenir ces dernières sur le deuxième support de manière rapprochée les unes des autres.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente un exemple de premier support au niveau duquel une puce a été fabriquée.
La figure 2A représente une étape de masquage avant gravure conduisant à réduire l'ancrage de la puce relativement au premier support.
La figure 2B montre en vue de dessus de l'étape de la figure précédente, cette dernière correspondant à une coupe suivant les lignes A-A de la figure 2B.
La figure 3 représente une étape ultérieure à celle des deux figures précédentes.
La figure 4 reflète un premier support sur lequel une puce est suspendue.
La figure 5 montre la formation d'un revêtement liquide, tel qu'une goutte.
La figure 6 présente la formation d'une couche intercalaire entre la puce et un deuxième support.
La figure 7 reflète la désolidarisation de la puce relativement au premier support.
La figure 8 montre un résultat final potentiel, de collage de la puce sur le deuxième support.
La figure 9 présente une variante avec une deuxième couche intercalaire pour un deuxième report.
La figure 10 montre le résultat du deuxième report.
Les figures 11 à 13 présentent une variante de réalisation avec auto-alignement des puces.
Les figures 14 et 15 montrent une possibilité de point de départ d'un procédé de réalisation de puces.
La figure 16 illustre une possibilité de succession de déplacements d'une puce pour la reporter.
Les figures 17 à 20 présentent des étapes successives de transfert de puces
La figure 21 en fournit une variante de réalisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

L'invention telle que définie dans la revendication 1 comprend les caractéristiques suivantes:
- La solidification comprend le placement de la surface d'assemblage 411 de la face 41 du deuxième support 4 à une température inférieure à une température de solidification de la couche intercalaire 3. La conduction thermique sert alors à refroidir la couche 3 et la solidifier.
- La formation de la couche intercalaire 3 comprend une formation d'un revêtement liquide sur la face avant 22 de la puce 2, puis le rapprochement du premier support 1 et du deuxième support 4 de sorte à mettre en contact le revêtement liquide et la surface d'assemblage 411 de la face 41 du deuxième support (4). La couche 3 est ainsi possiblement formée avec des techniques conventionnelles sur une surface, qui peut être plane.
- Le placement de la surface d'assemblage 411 de la face 41 du deuxième support 4 à une température inférieure à une température de solidification de la couche intercalaire 3 est opéré avant la mise en contact du revêtement liquide avec la surface d'assemblage 411 de la face 41 du deuxième support 4. Cela peut par exemple accélérer le procédé. Selon une variante non conforme à la présente invention, on peut refroidir après mise en contact, par exemple dans le cas où plusieurs puces sont sur le premier support 1, la mise en contact étant meilleure si la couche 3 ne passe pas rapidement à l'état solide.

Les caractéristiques suivantes sont optionnelles et peuvent éventuellement être utilisées en association ou alternativement :
- La formation de la couche intercalaire 3 comprend une phase de condensation, sur la face avant 22 de la puce 2, d'un composé d'une atmosphère dans laquelle sont placés le premier support 1 et le deuxième support 4.
- Le procédé comprend, de préférence après la désolidarisation, une élimination de la couche intercalaire 3, et un collage direct de la face avant 22 de la puce 2 sur la surface d'assemblage 411 de la face 41 du deuxième support 4 ; Cela permet un report direct de manière simple ; le matériau de la couche intercalaire passe alors avantageusement par les trois états : liquide, solide et gazeux.
- L'élimination de la couche intercalaire 3 comprend une évaporation de la couche intercalaire 3 ; cela peut se faire par chauffage du deuxième support 4 au-delà d'une température d'évaporation de la couche intercalaire 3. On peut aussi chauffer pour retourner à l'état liquide et ensuite laisser s'évaporer le liquide sans chauffe supplémentaire ; pour cela on place l'ensemble dans une atmosphère non saturée en vapeur d'eau ; pour accélérer le processus, on peut diminuer l'humidité de l'atmosphère ; pour cela on peut utiliser un dessiccateur, on peut introduire un gaz sec ou on peut augmenter la température de l'atmosphère ce qui réduite d'autant l'humidité. Il est aussi possible d'augmenter la température du liquide mais sans aller jusqu'à une ébullition qui pourrait déstabiliser la puce. On peut ainsi contrôler le comportement de la couche intercalaire grâce à la température du deuxième support, au moins durant une partie des phases de modification de cette couche.
- La surface d'assemblage 411 de la face 41 du deuxième support 4 est formée avec les mêmes dimensions que la face avant 22 de la puce 2.
- La face avant 22 de la puce 2 et la surface d'assemblage 411 de la face 41 du deuxième support 4 sont hydrophiles, et la surface d'assemblage de la face 41 du deuxième support 4 est entourée d'une surface hydrophobe. Cela permet un phénomène d'auto-alignement. Ce peut aussi être le cas de la surface d'assemblage 511 d'un troisième substrat.
- La surface d'assemblage 411 de la face 41 du deuxième support 4 est disposée en saillie sur la face du deuxième support 4. Elle est ainsi physiquement individualisée, ce qui peut être favorable à la précision de localisation du liquide de la couche intercalaire, tel une goutte. Ce peut aussi être le cas de la surface d'assemblage 511 d'un troisième substrat.
- La face avant 22 de la puce 2 et la surface d'assemblage 411 de la face 41 du deuxième support 4 sont hydrophobes. Cette option permet par exemple de favoriser l'adhésion sur un autre support hydrophile, ultérieurement, la liaison hydrophobe étant plus faible que celle d'une surface hydrophile.
- Le procédé peut comprendre en outre, après la désolidarisation, une solidarisation d'une face arrière 21, opposée à la face avant 22, de la puce 2 sur une face 51 d'un troisième support 5, puis une séparation de la face avant 22 de la puce 2 et de la surface d'assemblage 411 de la face 41 du deuxième support 4. La couche intercalaire 3 peut être replacée à l'état liquide avant la séparation de la face avant 22 de la puce 2.
- Le procédé comprend éventuellement, après la désolidarisation :
   - une formation d'une deuxième couche intercalaire 6 à l'état liquide entre, et au contact de, une face arrière 21 de la puce 2, opposée à la face avant 22, et une surface d'assemblage d'une face 51 d'un troisième support 5, la face arrière 21 de la puce 2 et la surface d'assemblage de la face 51 du troisième support 5 étant hydrophiles, puis,
   - alors que la couche intercalaire 3 et la deuxième couche intercalaire 6 sont à l'état liquide, une séparation de la face avant 22 de la puce 2 et de la surface d'assemblage411 de la face 41 du deuxième support 4 par déplacement relatif du deuxième support 4 et du troisième support 5.
- Selon une possibilité, le procédé comprend, après la séparation, une élimination de la deuxième couche intercalaire 6, et un collage direct de la face arrière 21 de la puce 2 sur la surface d'assemblage de la face 51 du troisième support 5.
- La surface d'assemblage 511 de la face 51 du troisième support 5 est formée avec les mêmes dimensions que la face arrière 21 de la puce 2.
- La surface d'assemblage 511 de la face 51 du troisième support 5 est disposée en saillie sur la face du troisième support 5.
- La couche intercalaire 3 et/ou la deuxième couche intercalaire 6 peut être formée par un film ; cela permet par exemple de mutualiser cette couche pour plusieurs puces. Par exemple, le report sur le troisième support 5 peut être collectif et le film est alors réalisé sur la surface de ce support, évitant une succession de dépôts de gouttes.

Eventuellement, le procédé comprend, avant la formation d'une couche intercalaire 3 :
alors que la puce 2 est contenue dans toute l'épaisseur d'une couche superficielle 13 du premier support 1 , un enlèvement d'une portion de la couche superficielle 13 configuré pour détourer la puce 2 tout en préservant au moins une zone d'ancrage 16 entre la puce 2 et la couche superficielle 13,
   - puis, un enlèvement d'une portion d'une couche sous-jacente 12 à la couche superficielle 13, configuré pour libérer une face arrière 21 de la puce 2, opposée à la face avant 22,
de sorte à suspendre la puce 2 par l'au moins une zone d'ancrage 16. Grâce à cette disposition, la puce n'est que peu retenue sur le premier support. D'une manière générale, dans ce mode de réalisation, le procédé comprend de préférence une phase de réduction de l'ancrage de la puce relativement au premier support, cette phase permettant de réduire une valeur de limite à la rupture de la liaison entre la puce et ce support.

Dans un mode de réalisation, le premier support 1 est une tête de collecte et de placement de puces, et la désolidarisation comprend une désactivation d'un système de maintien de la puce sur la tête de collecte et de placement.

La formation de la couche intercalaire 3, peut comprendre successivement :
- une collecte de la puce 2, par une face arrière 21 opposée à la face avant 22, par la tête de collecte et de placement 210 depuis un support initial 7 de la puce, la collecte comprenant une activation du système de maintien de la puce 2;
- un premier déplacement de la tête de collecte et de placement jusqu'à un outil de dépôt de goutte 400;
- une formation d'une goutte, destinée à former la couche intercalaire 3, sur la face avant 22 de la puce 2 au moyen de l'outil de dépôt de goutte 400;
- un deuxième déplacement de la tête de collecte et de placement jusqu'au deuxième support 4, configuré pour que la goutte entre en contact avec la face 41 du support 4.

Eventuellement, on opère une répétition du transfert en utilisant la tête de collecte et de placement de manière successive, pour une pluralité de puces, de sorte à placer la pluralité de puces 2 sur la face 41 du deuxième support 4.

Suivant une possibilité, on utilise un substrat donneur flexible, typiquement le premier support 1.

Le procédé peut être opéré de manière simultanée pour une pluralité de puces.

Il pourra notamment s'appliquer à des transferts de puces de très petites dimensions, difficilement manipulables individuellement. Mais une autre application est le transfert individuel de puces de manière rapprochée sur la face d'un support.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant, soit directement à son contact, soit en étant séparée d'elle par un film, ou encore une autre couche ou un autre élément. Une couche peut par ailleurs être composée de plusieurs sous-couches d'un même matériau ou de matériaux différents.

Il est précisé que dans le cadre de la présente invention, l'épaisseur d'une couche ou du substrat se mesure selon une direction perpendiculaire à la surface selon laquelle cette couche ou ce substrat présente son extension maximale. Si une couche n'est pas totalement plane, notamment parce qu'elle présente des défauts qui sont susceptibles d'être en relief sur la face exposée de ladite couche, l'épaisseur s'entend de la dimension de cette couche en dehors de ses défauts.

Il est précisé que dans le cadre de la présente invention, le terme « puce » s'entend de tout élément microélectronique destiné à être transféré sur un dispositif, en particulier sur un support de plus grande dimension que la puce. Ces puces peuvent être processées ou non, ou encore réalisées à base de silicium ou à base d'autres matériaux comme l'InP, par exemple, ou encore aussi être en AsGa, SiC, Silice, Germanium, Saphir et avoir en surface des couches de matériaux comme la silice, du nitrure de silicium, des métaux comme le cuivre ou le titane, et toutes autres couches connues de la microélectronique (HfO2, SiOC, AIN, Al2O3, GaN, ...).

Typiquement, les puces peuvent contenir des circuits intégrés, qui peuvent être connectés à l'extérieur au moyen de parties d'interconnexion électrique. Ces interconnexions peuvent être réalisées directement à l'interface de collage. Ces parties de raccordement électrique peuvent avoir des dimensions inférieures à 5 µm, ce qui implique une précision de placement des puces très élevée, de l'ordre d'un micromètre par exemple.

Les puces peuvent faire l'objet d'un traitement préalable à la mise en oeuvre du transfert ici proposé, mais aussi d'un traitement ultérieur. De tels traitements peuvent correspondre à l'intégration de circuits, de vias ou de tout composant actif ou passif. Par exemple, le transfert décrit selon l'invention peut être réalisé sur la base de puces non encore totalement formées, éventuellement encore simplement constituées d'un simple bloc de matière homogène destiné à être transformé ultérieurement.

Les puces peuvent avoir une forme parallélépipédique préférentiellement rectangle, et, pour le moins, disposer d'une section transversale rectangulaire, voire carrée, permettant de délimiter une face avant et une face arrière ayant une telle forme de section. À titre d'exemple, on peut mettre en oeuvre l'invention avec des puces de très petite dimension, par exemple de moins de 250 µm dans leur dimension la plus longue.

Un aspect de l'invention tire profit de la solidification d'une couche intercalaire entre une face d'une puce et son support, de sorte à extraire la puce de ce dernier.

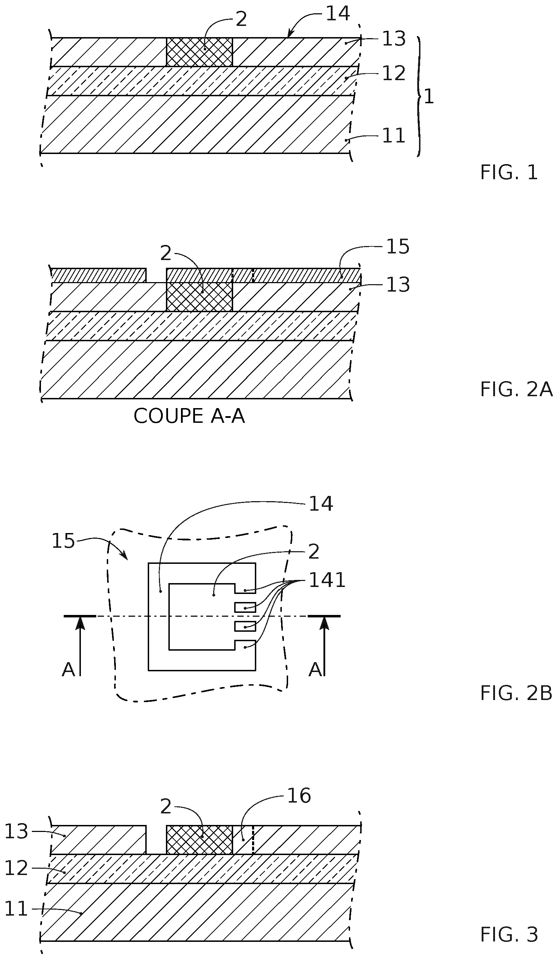

Les figures 1 à 8 correspondent à une suite d'étapes potentielles.

Un premier mode de réalisation de l'invention. Cet exemple est particulièrement adapté à la manipulation de puces, de manière collective, et/ou sans avoir à recourir à des outils de collecte et de placement des puces.

Dans un premier temps, les figures 1 à 4 donnent un exemple de préparation d'un premier support 1 qui peut constituer le substrat de départ d'une puce, et de préférence d'une pluralité de puces. En effet, un intérêt de l'invention est de pouvoir mettre en oeuvre de manière collective tout ou partie des étapes de transfert de puces. Ainsi, la description donnée ci-après en ce qui concerne une puce peut être généralisée pour un transfert simultané de plusieurs puces à partir du premier support.

En figure 1, ce support 1 est non limitativement représenté sous la forme d'un substrat du type semi-conducteur (typiquement du silicium) sur isolant, connu sous l'acronyme SOI. Par exemple, une couche de base 11 forme la majeure partie de l'épaisseur du support 1, et est surmontée d'une couche enterrée 12, par exemple de nature diélectrique, qui est généralement formée d'oxyde de silicium. La couche 12 peut représenter une épaisseur de 400 nm à titre d'illustration. Elle est surmontée d'une couche superficielle 13, généralement très fine (par exemple de 100 nm) par exemple en silicium monocristallin, qui sert à construire des parties ultérieures de dispositifs microélectroniques, tels que des puces. Dans cet exemple, une puce 2 a été construite dans la couche 13, ou est simplement une portion de cette couche que l'on souhaite extraire. Elle s'y étend suivant toute l'épaisseur de la couche 13, de sorte que la face supérieure de la puce 2, ci-après dénommée face avant 22, est exposée à la face 14 de la couche superficielle 13. De préférence, la face arrière 21, opposée à la face 22, est située à l'interface avec la couche sous-jacente 12.

Une telle structure est ici exploitée pour parvenir à limiter l'ancrage de la puce 2 relativement au premier support 1, de sorte à autoriser, ensuite, une désolidarisation.

Dans ce contexte, la figure 2A présente une étape de masquage par une couche 15, faite par exemple d'une résine de photolithographie, délimitant une surface de la face 14 restant exposée. Comme le montre plus précisément la figure 2B, le masquage est organisé pour ne laisser subsister qu'une petite portion de raccordement entre la puce 2 et la couche superficielle 13 dans laquelle elle est logée. En particulier, des zones de délimitation d'ancrage 141 permettent, in fine, de ne laisser subsister que des portions réduites de raccordement de la puce 2.

Comme le montre la figure 2B, la zone non masquée de la couche 13 forme un contour, qui peut être globalement homothétique, autour de la section de la puce 2. Ce contour n'est cependant pas fermé, en ce sens que les zones 141 sont discontinues. Éventuellement, une seule rupture de continuité du contour défini par le masque suffit. La tranchée ainsi formée peut être par exemple d'une largeur de 50 µm autour de la puce. Cette dernière est, dans l'exemple représenté, de section carrée, et par exemple de 0,5x0,5 mm².

Ainsi, lorsqu'une gravure (notamment une gravure ionique) est opérée dans la couche superficielle 13, par les zones non masquées de la face 14, on parvient à détourer très majoritairement la puce 2, qui ne se retrouve reliée à la couche superficielle que par une zone d'ancrage 16 formée par le ou les ponts précédemment définis dans le masque. C'est le résultat visible la figure 3. Dans l'exemple dimensionnel donné précédemment, des ponts d'ancrage, notamment quatre ponts d'ancrage, peuvent subsister avec une largeur individuelle de 50 µm. On verra ultérieurement que la résistance à la rupture de la zone d'ancrage 16 est adaptée de sorte à pouvoir être surmontée par une force de désolidarisation qui sera appliquée par un deuxième support 4.

On produit ensuite une mise en suspension de la puce 2 par une excavation de la couche sous-jacente 12. Dans le cas où cette dernière est en oxyde de silicium, on peut réaliser une gravure, en particulier par acide fluorhydrique, en phase liquide ou en phase vapeur. Le contrôle de temps de gravure assure la forme de la cavité 121 souhaitée dans la couche 12. Il ressort que la puce 2 n'est plus reliée au premier support 20 que par la zone d'ancrage 16, de section réduite.

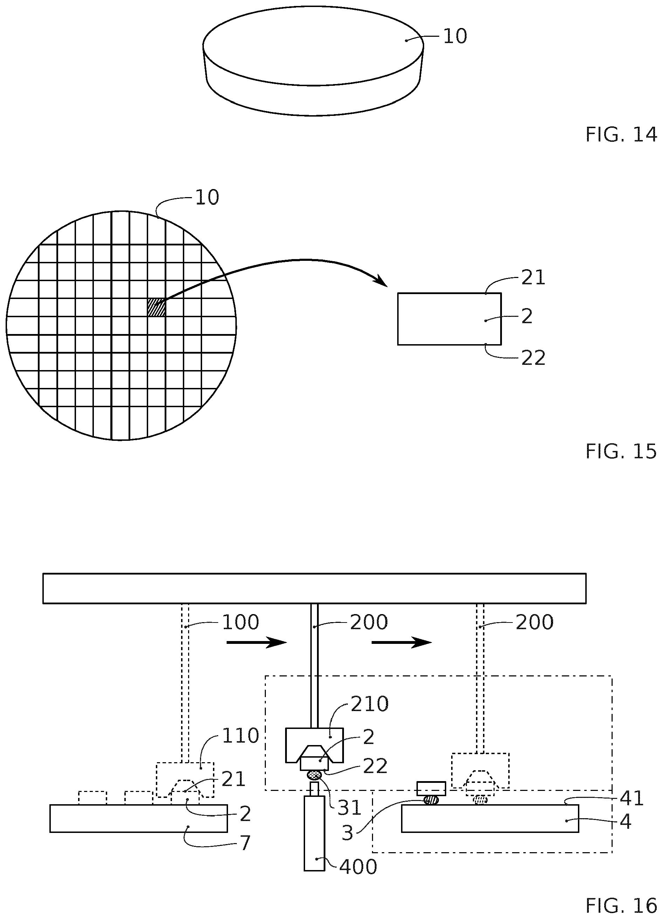

Le mode de réalisation illustré pour le premier support 1 n'est pas limitatif. En particulier, on entend ici par support tout élément apte à recevoir, au moins de manière provisoire, la ou les puces. Il pourra s'agir d'une plaque, d'un substrat simple ou plus complexe comme dans le cas du substrat SOI précédemment décrit. Et plus loin, en référence aux illustrations des figures 14 à 21, il pourra aussi s'agir d'un organe de machine, et par exemple d'une tête de déplacement individuel ou collectif de puces ; par exemple, ce peut être la tête d'un outil de collecte et de placement (généralement connu sous le vocable anglais « pick and place »). Il est possible également que le premier support 1 soit un substrat flexible (tape en anglais) formé d'un film porteur surmonté d'un film adhésif. Le film porteur peut par exemple être à base d'un polymère (PET ou PVC par exemple) et le film adhésif à base par exemple d'acrylate ou de silicone. La puce 2 est alors solidaire du film adhésif. Une pluralité de puces 2 peuvent être disposées sur le film adhésif par exemple selon un arrangement régulier en ligne ou sous forme de matrice. Le film souple peut optionnellement être solidaire d'un support rigide du côté du film porteur.

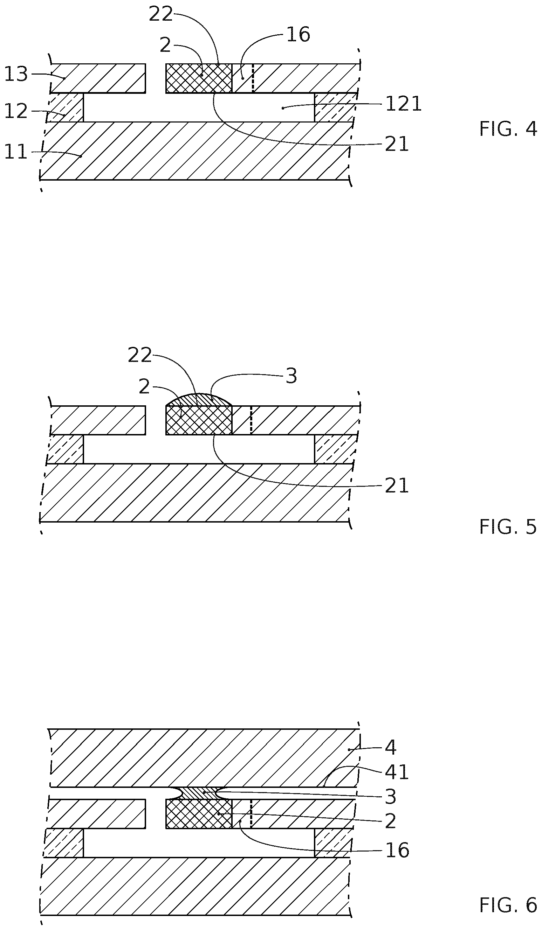

La figure 5 montre une étape de formation d'une goutte destinée à former une couche intercalaire 3, à l'état liquide à ce stade. De préférence, le liquide employé est de l'eau, ou majoritairement, en masse, à base d'eau. Il n'est cependant pas exclu que d'autres liquides soient employés, par exemple pour ajuster le point de solidification ou le point de rosée ou encore la viscosité souhaitée aux températures de travail.

Suivant un mode de réalisation non limitatif, on peut auparavant traiter la face avant 22 de la puce 2 pour la rendre hydrophile, ce traitement épargnant avantageusement le reste de la face du premier support 1.

À titre d'exemple, il peut s'agir d'un traitement à base de rayons ultraviolets/ozone pendant deux minutes. Alternativement ou en complément, certaines surfaces peuvent être rendues hydrophobes, de sorte à obtenir le différentiel de force capillaire souhaité ; ce traitement est par exemple mis en oeuvre avec de l'acide fluorhydrique si la face correspondante de la puce ou du support est en silicium.

Le caractère hydrophile s'entend d'une affinité avec l'eau ; par extension ce terme est ici aussi employé pour désigner, de manière plus générique, une affinité d'une surface avec le liquide employé pour la couche 3 (et plus loin pour la couche 6) même s'il ne s'agit pas d'eau. Le caractère hydrophobe s'entend d'une moindre affinité avec l'eau et, par extension, d'une moindre affinité avec le liquide employé. On entend ici comme hydrophile une surface plus hydrophile qu'une surface définie comme hydrophobe. Une surface hydrophile aura tendance à plus étaler le liquide qu'une surface hydrophobe ; pour une goutte, l'angle défini par la surface et la tangente de la goutte à sa base sera plus grand pour un liquide hydrophobe. Il peut être aigu pour une surface hydrophile et obtus pour une surface hydrophobe.

Grâce à ce traitement, le dépôt de la goutte (d'eau) peut être précisément délimité à la surface de la face avant 22 de la puce 2. La face avant 22 se retrouve par ailleurs avantageusement plus hydrophile que la face arrière 21 de la puce 2.

Il peut être utile de placer le premier support 1 à une température faible, pour préserver l'eau liquide durant les opérations. Par exemple, on peut refroidir le premier support avec une consigne de 3°C. Cumulativement ou alternativement, on peut contrôler l'occurrence la goutte dans le cas des figures, ne s'évapore pas ou pas trop. Par exemple, l'atmosphère de mise en oeuvre de la formation de la couche liquide peut comprendre une pression de vapeur saturante pour la température du premier support 1, ou juste en dessous de cette température, à moins de 50% (par exemple pour une température de 3°C, une pression partielle de vapeur de 6,6 mbar environ suffit ; si on se place 50% en dessous de cette pression (c'est-à-dire autour de 4 mbar) la température de rosée est alors de -4°C.

La couche liquide 3 peut être réalisée par dépôt d'une goutte d'eau ; par exemple, une goutte de 100 µm de diamètre sur la surface de la puce peut être déposée par un outil de dépôt de gouttes existant. Le résultat produit correspond à celui de la figure 5. Le caractère hydrophile sélectif de la face avant 22 de la puce 2 délimite précisément la zone de formation de la couche liquide.

Le transfert en tant que tel sur un deuxième support 4 peut alors être entamé.

À la figure 6, on a représenté une approche de ce deuxième support 4 en direction du matériau liquide jusqu'à son accostage, de sorte à réaliser la couche intercalaire 3 formant une interface entre une surface d'assemblage de la puce sur la face 41 du deuxième support 4 et la face avant 22 de la puce 2.

Dans un mode de réalisation, le deuxième support 4 est une poignée sur laquelle la ou les puces sont transférées de manière intermédiaire, avant un autre report vers un troisième support. Dans ce cadre, il peut s'agir d'un substrat monobloc, par exemple en silicium. Suivant un autre mode de réalisation, le deuxième support 4 est le substrat de destination de la puce 2.

L'approche du deuxième support 4 peut être réalisée sur une machine conventionnelle à mandrin par lequel ce support 4 est maintenu.

C'est par la température du deuxième support 4 que l'on parvient à solidifier le matériau de la couche intercalaire 3. À cet effet, on peut placer le deuxième support 4 à une température adéquate, à savoir inférieure à la température de solidification du liquide de la couche 3, avant son approche puis à son accostage représenté à la figure 6. Par exemple, dans le cas de l'eau, on peut placer le support 4 à une température de -3°C. Des techniques de refroidissement du type utilisant l'effet Peltier pourront être employées d'une manière générale pour contrôler la température des parties de dispositifs pertinentes, et en particulier le deuxième support 4.

De préférence, l'atmosphère qui entoure les supports 1 et 4 et à une température de rosée inférieure à la température de la surface du deuxième support 4. À cet effet, on diminue l'humidité juste avant l'accostage du deuxième support 4 sur la couche 3 si c'est nécessaire.

On comprend que lorsque le deuxième support 4 touche la couche 3, cette dernière se solidifie (c'est-à-dire gèle dans le cas de l'eau).

Ce processus assure une adhésion relativement élevée de la puce 2 sur le deuxième support 4. Le niveau d'adhésion est choisi, en correspondance avec la limite à la rupture de la liaison 16, de sorte que la puce 2 reste solidaire du deuxième support 4 lorsque ce dernier est éloigné du premier support 1. Eventuellement, c'est le premier support (ou les deux supports) qui est éloigné. Avantageusement, le mouvement relatif des supports 1 et 4 induit une sollicitation en flexion de la liaison 16 (qui peut être sous forme d'une ou plusieurs poutres, ou ponts).

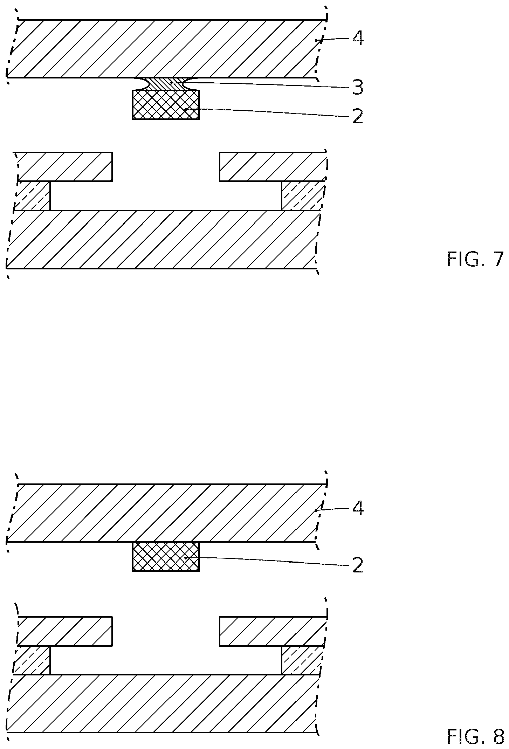

Cette désolidarisation du support 20 est représentée à la figure 7 de manière schématique, la liaison 16 rompue n'y étant plus représentée par simplification. Toute autre forme de solidarisation entre dans le cadre de l'invention, par rupture d'une partie mécanique comme dans le cas de la figure 7 ou par tout autre moyen.

Suivant une possibilité représentée à la figure 8, une étape suivante consiste à éliminer la couche 3. À cette fin, il est possible d'augmenter la température du deuxième support 4, par exemple jusqu'à 20°C pour faire fondre la goutte d'eau initialement sous forme de glace. De préférence, le seuil de 100°C n'est pas dépassé lors de cette chauffe.

Lorsque que la couche 3 est éliminée totalement, il en résulte un collage direct de la face avant 22 de la puce 2 sur le deuxième support 4.

Suivant une possibilité alternative non conforme à la présente invention, avant la phase d'approche et d'accostage du deuxième support 4 sur le revêtement liquide formant la couche 3, la température du deuxième support 4 reste au-dessus de la température de solidification du liquide utilisé (typiquement au-dessus de 0 °C dans le cas de l'eau). La température du deuxième support 4 n'est abaissée qu'ensuite, en dessous de cette température de solidification. Cette disposition est particulièrement avantageuse dans le cas d'un transfert collectif de plusieurs puces. En effet, il est dans ce cas plus simple que l'accostage se produise sans solidification immédiate du liquide.

Suivant une autre variante, pour la formation de la couche intercalaire liquide 3, on opère par condensation en diminuant la température du premier support 1 jusqu'à la placer en dessous de la température de rosée de l'atmosphère (typiquement de l'air) environnant ce premier support 1. Par exemple, on peut fixer l'humidité de l'atmosphère pour que la température de rosée soit de 6 °C. On place alors le premier support 1 à une température inférieure à la température de rosée, par exemple 4°C. Des gouttelettes se forment, en particulier sur les parties hydrophiles au détriment des parties hydrophobes. La condensation se trouve alors concentrée sur la face avant 22 de la puce.

Éventuellement, après accostage du deuxième support 4 sur la couche intercalaire 3, on peut abaisser l'humidité de l'air pour avoir une température de rosée inférieure, par exemple de -5 °C, et on abaisse la température du deuxième substrat comme prévu précédemment, par exemple à -3°C. Dans cette variante, comme dans le cas précédent, la désolidarisation de la puce relativement au premier support 1 s'opère lorsque la couche intercalaire 3 est solide, de sorte à rompre la liaison 16. Comme précédemment également, on peut alors éliminer le liquide et procédé un collage direct, de préférence auto aligné en jouant sur le caractère hydrophile des surfaces mises en jeu par le collage direct.

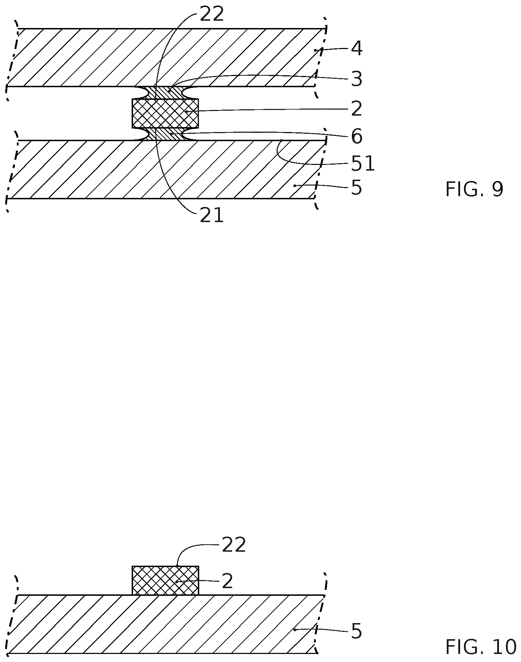

Suivant une possibilité évoquée précédemment, le deuxième support 4 n'est que transitoire. Cette variante correspond à la réalisation des figures 9 et 10.

Ainsi, à la figure 9, après la désolidarisation de la puce 2 relativement au premier support 1, la puce 2 est maintenue sur le deuxième support 4 par la couche intercalaire 3 toujours à l'état solide. Cet état autorise une manipulation supplémentaire pour transférer à nouveau la puce 2 en direction de la face 51 d'un troisième support 5.

Ce transfert emploie une couche intercalaire 6 à l'état liquide. Cette couche 6 est formée sur une face 51 du substrat 5. Le liquide employé peut être de l'eau comme précédemment. On peut utiliser les descriptifs donnés dans le contexte de la couche 3 pour la formation de la couche 6, par dépôt de goutte ou par condensation.

On peut aussi par exemple mettre en oeuvre une technique de formation d'un film d'eau, avantageusement désionisée, étalée sur la face 51 du troisième substrat 5. On peut utiliser un procédé de centrifugation, par exemple à 30 tr/m pendant 20 secondes pour ne laisser subsister sur la face 51 qu'un film d'eau d'une épaisseur de l'ordre de 50 à 75 µm. Cette disposition a l'avantage d'assurer une couverture complète de la face 51, utile dans le cas d'un report collective d'une pluralité de puces 2.

On comprend que, lorsque le troisième support 5 est rapproché du deuxième support 4 par la face arrière 21 de la puce 2, un pont capillaire apparaît entre cette face arrière 21 et la face 51 du troisième support 5. Cette phase de rapprochement et d'accostage peut être réalisée alors même que la couche intercalaire 3 est toujours à l'état solide, mais peut aussi être réalisée alors que la couche 3 est déjà revenue à l'état liquide par chauffage du deuxième support 4.

On aura pris soin de s'assurer que la force capillaire entre la face 21 et la face 51 par la couche intercalaire 6 soit supérieure à celle entre la face 22 et la face 41 par la couche intercalaire 3.

De la sorte, lorsque les deux supports 4, 5 sont éloignés l'un de l'autre, la couche intercalaire 3 étant à l'état liquide, la puce 2 reste solidaire du troisième support 5 au détriment du deuxième 4. Après élimination de la couche 6, par exemple par séchage de l'eau, la puce 2 se retrouve collée, par collage direct, sur le troisième support 5.

Pour assurer des forces capillaires différenciées entre celle produite par la couche 3 et celle produite par la couche 6, on peut jouer sur un caractère plus hydrophile des surfaces 21 et 51 reliées par la couche 6, relativement aux surfaces 22 et 41 reliées par la couche 3. En particulier, un traitement de surface peut être réalisé sur les surfaces 21 et 51 pour les rendre hydrophile. Un traitement comme indiqué précédemment peut être mis en oeuvre.

Il est aussi possible de créer la deuxième couche intercalaire 6 en changeant l'humidité (ou la température de rosée) de l'atmosphère entourant la puce 2. En effet, si on augmente l'humidité pour que la température de rosée dépasse la température du support 4 et de la puce 2, des gouttes d'eau vont apparaitre sur la face hydrophile (ici la face arrière 21) de la puce 2. Le support 5 sec peut alors être approché et contacter les gouttes d'eau en face arrière 21 de la puce 2. Comme la température de rosée d'une surface hydrophile est toujours légèrement inférieure à la température de rosée d'une surface hydrophobe, si on se place juste au-dessus de la température de rosée hydrophile, il est possible d'obtenir seulement des gouttes d'eau sur la face arrière 21 de la puce 2. Cependant même si on se place au-dessus de la température de rosée des surfaces hydrophobes, comme la puce 2 n'est pas dans le même plan que le deuxième support 4, il sera toujours possible de ne contacter et transférer que la puce avec le substrat 3.

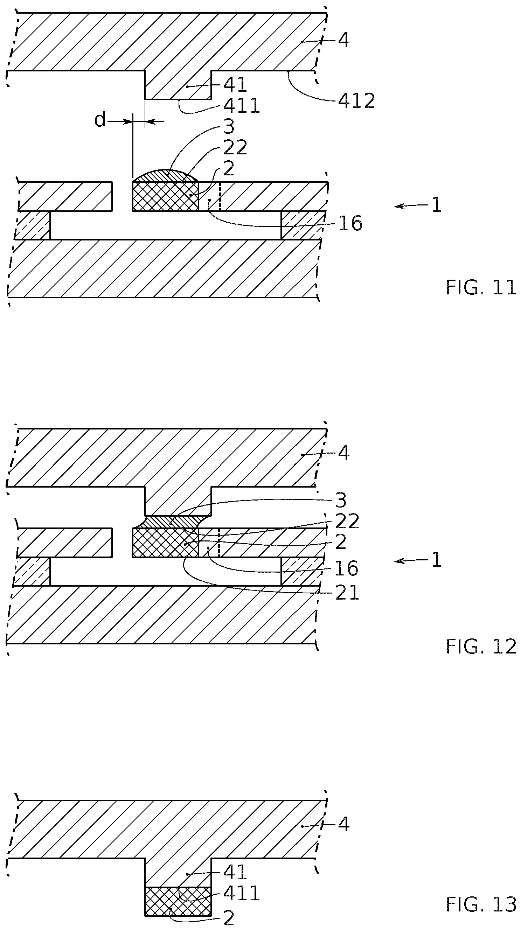

Les figures 11 à 13 présentent une autre variante de réalisation, combinable avec les indications précédentes.

En effet, il est possible d'utiliser un rattrapage de décalage entre un premier support et un deuxième support lors de l'opération de transfert. La figure 11 présente comme précédemment un premier support 1 au sein duquel une puce 2 est suspendu, avec une liaison faible relativement au support. Une couche intercalaire 3, comme précédemment sous forme d'une goutte, revêt la face avant 22 de la puce 2.

Cette fois, le deuxième support 4 présente une face 41 dotée d'une surface 411 réalisant la surface d'assemblage avec la puce 2 et la surfaces 411 est en saillie relativement à une surface périphérique 412 de la face 41. On comprend que cette disposition permet de privilégier une mise en contact du matériau de la couche 3 avec la surface 411, plutôt qu'avec la surface 412. De préférence, la surface 411 est par ailleurs hydrophile (on peut encore une fois se référer au traitement évoqué précédemment pour la rendre hydrophile) alors que la surface 412 est hydrophobe. Les flancs autour de la surface 411 font de préférence partie de la surface hydrophobe.

De par cette configuration physique et chimique, la goutte va avoir une tendance naturelle à adhérer sur la surface d'assemblage 411. Et ce même s'il existe un décalage latéral, dans le plan de la face 14 du premier support 1 entre la puce 2 et la surfaces d'assemblage 411. Ce décalage est ici représenté par la cote d sur la figure 11.

La figure 12 montre que, malgré le décalage, la couche 3 forme un pont capillaire entre la surface 411 et la face avant 22. Après élimination de la couche 3, le collage direct produit est donc précisément localisé sur la surface d'assemblage 411 souhaité, ce que révèle la figure 13.

Il est entendu que la disposition en saillie de la surface d'assemblage 411, et avantageusement hydrophile relativement à la surface périphérique 412, ainsi utilisée sur le deuxième support 4 peut être appliquée, mutatis mutandis, dans le cas du mode de réalisation induisant un deuxième transfert, comme représenté à la figure 9. Dans ce cas, c'est avantageusement le troisième support 5 qui est configurée pour présenter une face 51 disposant d'une surface d'assemblage hydrophile et/ou en saillie, relativement à la zone de la face 51 qui l'entoure.

De préférence, la surface hydrophile et/ou en saillie destinée à coopérer avec la puce présente une même dimension que la face de la puce correspondante, qu'il s'agisse du cas du deuxième support 4 ou du troisième support 5.

Les figures 14 à 21 présentent un enchaînement d'étapes potentielles suivant un autre mode de réalisation. Cet exemple est particulièrement avantageux pour le report individuel de puces avec un faible espacement de ces dernières sur la face du deuxième support. Cela permet par exemple ultérieurement un report additionnel, qui peut être collectif, sur un troisième support, avec une densité finale de puces élevée et/ou un alignement précis de chaque puce.

À la figure 14, une plaque 10 d'un matériau destiné à être la base de fabrication de la puce est utilisée. Par exemple, il peut s'agir d'une plaque d'InP, potentiellement de 50 mm de diamètre, avec une épaisseur de l'ordre de 350 µm (+/- 25 µm). Avantageusement, un film antiadhésif est déposé, par exemple par un étalement centrifuge (connu sous le vocable anglais spin coating), avec une machine qui tient la plaque par sa tranche de sorte à ne pas toucher la face avant de cette dernière.

La figure 15 révèle une singularisation de puces 2 à partir de la plaque 10. Il peut s'agir d'une découpe. La taille des puces n'est pas limitative, mais il peut s'agir de puces de l'ordre de 10x10 mm². La face avant correspond ici à la référence 22 et la face arrière à la référence 21. C'est la surface 22 qui reçoit le film anti-adhésif pour rendre cette face hydrophobe.

Chaque puce 2 peut être saisie par un dispositif de déplacement 100 comprenant une tête de collecte et de placement 110. Comme indiqué précédemment, on peut utiliser la technique connue sous le vocable anglais «pick and place » ici traduit par collecte et placement. La tête de collecte et de placement 110 comporte un système de maintien d'une puce. À cet effet, elle peut comprendre, sur sa partie destinée à être positionnée en regard de la face de la puce 2, une cavité apte à recevoir, au moins en partie, la puce. Une forme pyramidale de cette cavité permet de ne pas toucher la face de la puce qui s'insère dans la cavité, en limitant un contact à la bordure de la face. La rétention de la puce peut être réalisée par une technique de pince retenant la puce par la tranche, ou encore par un effet dépressionnaire (effet ventouse réalisé par un vide) ou par un effet venturi. Ces cas ne sont pas limitatifs. D'une manière générale, on pourra utiliser tout système de maintien de la puce sur la tête de collecte et de placement. L'activation d'un tel système permettra de retenir la puce, et, inversement, sa désactivation, permettra de la libérer.

La tête 110 permet, selon le cas de la figure 16, de disposer là où les puces 2 sur un support initial 7, qui est par exemple une poignée. Cette dernière était simplement schématisée sous la forme d'une plaque à la surface plane. Il peut cependant s'agir d'une poignée plus complexe, par exemple du type contenant des cavités de réception individuelle des puces. Cette étape peut être utile pour réaliser une préparation de surface des puces 2, et en particulier de la face arrière 21. Par exemple, il peut s'agir d'une décontamination des hydrocarbures, ce qui peut être effectué avec un plasma de dioxygène. En complément, ou alternativement, il peut s'agir d'une décontamination particulaire, typiquement par traitement mégasonique.

Un dispositif de placement 200 est employé pour opérer un nouveau transfert de puces 2. Le dispositif 200 pourra être du type précédemment décrit pour le dispositif de déplacement initial 100. Il peut, éventuellement, s'agir du même dispositif. Dans ce mode de réalisation, c'est le dispositif 200 qui fournit le premier support 1 par sa tête de collecte et de placement. À cette étape, la puce 2 est donc solidaire du support 1 formé par la tête du dispositif 200, le système de maintien de cette tête étant activé pour retenir la puce 2.

Lors de ce nouveau déplacement, on atteint un outil de dépôt de goutte 400 qui permet de déposer un revêtement liquide sous forme d'une goutte 31 sur la face avant 22 de la puce 2. On pourra utiliser un outil de dépôt de goutte existant sur le marché, tels que ceux vendus sous la marque Microdrop^{®}.

Éventuellement, on peut contrôler l'humidité de l'atmosphère environnant l'outil 400 pour éviter que la goutte 31 ne s'évapore trop rapidement.

En allant plus avant vers la droite de la figure 16, le dispositif 200 est à nouveau employé pour déplacer la puce 2, dont la face 22 porte la goutte 31, vers le deuxième support 4. Là encore, l'atmosphère peut être contrôlée pour éviter une évaporation trop rapide. Un cadre pointillé mixte supérieur schématise cette atmosphère.

La mise en contact de la goutte 31 avec la face 41 du deuxième substrat 4 conduit à réaliser la couche intercalaire 3. Le deuxième substrat 4 est placé à une température configurée pour que le contact avec la goutte 31 produise une solidification. Selon l'invention, le refroidissement est réalisé en anticipation relativement à la mise en contact sur la face 41, également dans le cas d'un report d'une pluralité de puces 2.

Le positionnement de la puce 2 sur la face 41 peut être réalisé de manière déterminée par rapport à des marques d'alignement présentent sur le substrat 4 et qui peuvent être détectées par le dispositif 200. On pourra atteindre une précision de positionnement par exemple de l'ordre de +- 10 µm.

Le support 4 peut par exemple être un substrat temporaire. Sa face 41 est avantageusement plane au niveau de la surface de réception des puces, sans nécessité de disposer de cavités individuelles pour leur maintien. Avantageusement la face 41 est hydrophobe comme la face 22 des puces 2.

Comme précédemment, le refroidissement de la matière de la couche intercalaire 3 la solidifie. La puce 2 se retrouve stabilisée et solidaire du deuxième support 4 durant cette phase.

La puce 2 peut alors être libérée du premier support. La désolidarisation pourra être effectuée en relâchant la préhension d'un tel organe sur la puce (par exemple : ouverture d'une pince, suppression d'un vide ou d'un effet venturi).

De préférence, une pluralité de puces est, à ce moment, présente sur le support 4, en répétant les manoeuvres de déplacement des dispositifs 100,200. Les puces peuvent se trouver très rapprochées sur la face 41 du deuxième support 4. Par exemple, la distance entre les puces peut-être inférieure ou égale à 100 µm, ce qui ne pourrait pas être atteint avec des techniques traditionnelles de maintien des puces sur un support doté de cavités de réception individuelle des puces.

Le volume entourant le deuxième substrat 4, représenté à la figure 16 par un cadre en pointillés mixtes inférieur, peut faire l'objet d'un contrôle de l'humidité de son atmosphère pour éviter un phénomène de condensation. Pour cela, l'atmosphère peut être du dioxyde de carbone suffisamment sec ; de l'azote (formant l'atmosphère environnant la partie supérieure de la puce) présent au-dessus de ce volume de dioxyde de carbone peut alors avoir une humidité différente et suffisante pour éviter que la goutte 31 ne s'évapore trop vite.

Postérieurement, on peut réaliser un report des puces 2 sur un troisième support 5.

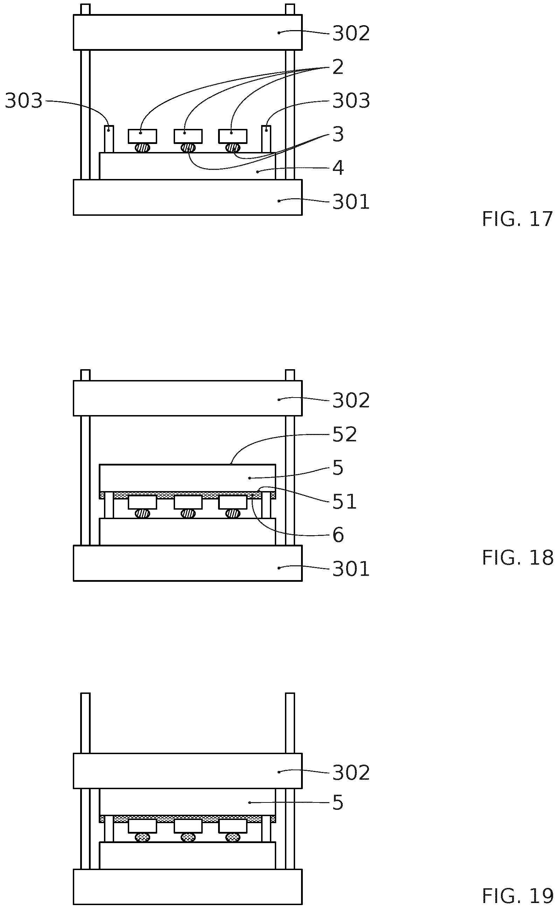

La succession d'étapes des figures 17 à 20 en donne un exemple.

À la figure 17, le premier support 4 toujours à une température permettant de maintenir la couche intercalaire 3 à l'état solide, est placé sur un mandrin 301. D'une manière générale, à ce stade, il conviendra de maintenir la couche 3 à l'état solide. Notamment, le mandrin peut être refroidi. En vue de préparer l'accostage d'un troisième support 5, des cales 303 sont, dans le cas illustré, positionnées sur la face 41 du support 4, de sorte à définir un écartement cible lors de l'accostage du troisième support 5, présenté plus loin. Dans l'exemple de puces issues d'une singularisation d'une plaque de 350 µm d'épaisseur, une cale de 375 µm de hauteur, suivant la dimension en épaisseur de la puce, pourra convenir, éventuellement avec une marge de +/- 5 µm.

De préférence, l'atmosphère environnant le mandrin 301 est elle aussi contrôlée pour éviter la condensation.

La machine portant le mandrin 301 comporte par ailleurs un deuxième mandrin 302 susceptible d'un mouvement de translation pour se rapprocher ou s'éloigner du premier mandrin 301, de sorte à fournir une fonction d'étau.

La figure 18 montre le placement du troisième support 5 au-dessus de l'empilement formé par le deuxième support 4, les gouttes 3 et les puces 2. Auparavant, un revêtement liquide est formé sur la face 51 du troisième support 5 destinée à recevoir la face 21 des puces 2. Avantageusement la face 51 est hydrophile comme les faces 21 des puces 2.

Ce revêtement, qui peut suivre les exemples donnés pour la couche intercalaire 3, et qui peut notamment être de l'eau ou à base d'eau, est avantageusement déposée sous forme d'un film. Il peut s'agir d'un film d'eau désionisée étalée sur la face 51. Les paramètres d'étalement fournis précédemment conviennent.

Bien entendu, on peut aussi avoir recours à des formations de gouttes pour chaque puce. Cependant, la réalisation d'un film permet d'obtenir, en une seule étape, une interface liquide servant à toutes les puces qui doivent être transférées.

Lorsque le troisième support 5 est posé, de préférence avec un alignement d'une précision d'au moins +/- 100 µm relativement au deuxième support 4, il est maintenu par les cales 303. Dans le même temps, l'épaisseur du film (ou des gouttes) est configuré pour que la face 51 du troisième support 5 soit mise en contact avec le liquide. On forme ainsi une deuxième couche intercalaire 6, entre la face 21 des puces 2 et la face 51 du troisième support 5.

En remontant la température du deuxième support 4, par exemple en coupant le refroidissement du mandrin 301, la couche intercalaire 3 revient à l'état liquide.

Préférentiellement, ce réchauffement n'atteint pas les 100°C et l'atmosphère environnante préserve un taux d'humidité qui évite que la deuxième couche intercalaire 6 ne s'évapore trop vite.

Une descente du deuxième mandrin 302 est représentée à la figure 19, de sorte à s'arrimer sur la face opposée du troisième support 5, par exemple par aspiration. L'étape de la figure 19 peut avoir lieu avant la liquéfaction de la couche intercalaire 3.

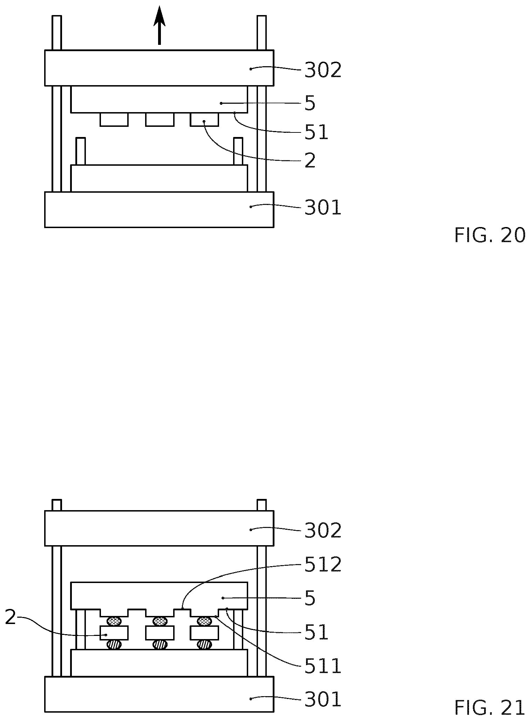

Néanmoins, ce retour à l'état liquide s'opère avant de désolidariser la puce 2 du deuxième substrat 4. Dans l'exemple fournit à la figure 20, la désolidarisation est produite par une remontée du deuxième mandrin 302, emmenant avec lui le troisième support 5.

Comme décrit précédemment, on peut jouer sur le caractère hydrophile ou hydrophobe des surfaces pour extraire les puces 2 du deuxième support 4. En particulier, les surfaces de la face arrière 22 de la puce 2 et de la face 41 du deuxième support 4, qui sont mises en relation par l'intermédiaire de la couche intercalaire 3, seront de préférence hydrophobes. Dans le même temps, les surfaces de la face avant 21 de la puce 2 et de la face 51 du troisième support 5, qui sont mises en relation par l'intermédiaire de la deuxième couche intercalaire 6, seront de préférence hydrophiles. Les exemples donnés précédemment pour obtenir le caractère hydrophobe ou hydrophile peuvent être retenus également dans ce mode de réalisation.

Le différentiel de force capillaire induit par les surfaces hydrophiles et hydrophobes permet de retenir les puces 2 sur le troisième support 5.

De préférence, la couche intercalaire 6 est ensuite éliminée. Il peut s'agir d'une évaporation naturelle de l'eau, en quelques heures. Les puces 200 s'en trouvent collées par collage direct sur le substrat 5 qui peut être le substrat final.

Comme dans les exemples précédents, la face 51 peut comporter, autour des surfaces d'assemblage avec la face 22 des puces, une surface périphérique hydrophobe de sorte à localiser le lieu du collage. On peut, à ce sujet, se référer aux phénomènes d'absorption des décalages d'alignement décrits en référence aux figures 11 à 13. Dans ce cas, il est aussi possible, en complément ou en alternative, d'avoir recours à une face 51 présentant une surface d'assemblage 511 en saillie relativement à une surface périphérique 512 de la face 51. Ce cas de figure correspond à la figure 21.

Les différents modes de réalisation représentés aux figures peuvent faire l'objet de combinaisons de tout ou partie de leurs caractéristiques, sans sortir du cadre de l'invention. C'est en particulier le cas dans l'exploitation des surfaces hydrophiles et hydrophobes pour gérer l'alignement et la précision de la localisation du collage des puces sur un support. C'est aussi le cas pour la gestion des phases de solidification et de liquéfaction des couches 3, 6 déposées à l'état liquide.

L'invention n'est pas limitée aux modes de réalisation précédemment décrits et s'étend à tous les modes de réalisation couverts par les revendications.

## Revendications

1. Procédé de transfert d'au moins une puce (2), depuis un premier support (1) vers un deuxième support (4), comprenant :
- alors que la puce (2) est solidaire du premier support (1), une formation d'une couche intercalaire (3) à l'état liquide entre, et au contact de, une face avant (22) de la puce (2) et une surface d'assemblage (411) d'une face (41) du deuxième support (4), et une solidification de la couche intercalaire (3)
- puis, une désolidarisation de la puce (2) relativement au premier support (1) tout en maintenant la couche intercalaire (3) à l'état solide, et dans lequel la solidification comprend le placement de la surface d'assemblage (411) de la face (41) du deuxième support (4) à une température inférieure à une température de solidification de la couche intercalaire (3), et **caractérisé en ce que** la formation de la couche intercalaire (3) comprend une formation d'un revêtement liquide destiné à former la couche intercalaire (3) sur la face avant (22) de la puce (2), puis un rapprochement du premier support (1) et du deuxième support (4) de sorte à mettre en contact le revêtement liquide et la surface d'assemblage (411) de la face (41) du deuxième support (4), et le placement de la surface d'assemblage (411) de la face (41) du deuxième support (4) à une température inférieure à une température de solidification de la couche intercalaire (3) est opéré avant la mise en contact du revêtement liquide avec la surface d'assemblage (411) de la face (41) du deuxième support (4).

2. Procédé selon la revendication 1, comprenant après la désolidarisation, une élimination de la couche intercalaire (3), et un collage direct de la face avant (22) de la puce (2) sur la surface d'assemblage (411) de la face (41) du deuxième support (4).

3. Procédé selon la revendication 2, dans lequel l'élimination de la couche intercalaire (3) comprend une évaporation de la couche intercalaire (3).

4. Procédé selon l'une quelconque des revendications 1 à 3, dans lequel la surface d'assemblage (411) de la face (41) du deuxième support (4) est formée avec les mêmes dimensions que la face avant (22) de la puce (2).

5. Procédé selon l'une quelconque des revendications 1 à 4, comprenant en outre, après la désolidarisation, une solidarisation d'une face arrière (21), opposée à la face avant (22), de la puce (2) sur une face (51) d'un troisième support (5), puis une séparation de la face avant (22) de la puce (2) et de la surface d'assemblage (411) de la face (41) du deuxième support (4).

6. Procédé selon la revendication 1, comprenant en outre, après la désolidarisation, une solidarisation d'une face arrière (21), opposée à la face avant (22), de la puce (2) sur une face (51) d'un troisième support (5), puis une séparation de la face avant (22) de la puce (2) et de la surface d'assemblage (411) de la face (41) du deuxième support (4), procédé dans lequel la couche intercalaire (3) est replacée à l'état liquide avant la séparation de la face avant (22) de la puce (2).

7. Procédé selon l'une quelconque des deux revendications précédentes, dans lequel la face avant (22) de la puce (2) et la surface d'assemblage (411) de la face (41) du deuxième support (4) sont hydrophobes, et dans lequel la solidarisation de la face arrière (21) de la puce (2) comprend :
- une formation d'une deuxième couche intercalaire (6) à l'état liquide entre, et au contact de, la face arrière (21) de la puce (2) et une surface d'assemblage de la face (51) du troisième support (5), la face arrière (21) de la puce (2) et la surface d'assemblage de la face (51) du troisième support (5) étant hydrophiles, puis,
- alors que la couche intercalaire (3) et la deuxième couche intercalaire (6) sont à l'état liquide, la séparation de la face avant (22) de la puce (2) et de la surface d'assemblage (411) de la face (41) du deuxième support (4) comprenant un déplacement relatif du deuxième support (4) et du troisième support (5).

8. Procédé selon la revendication précédente, dans lequel la surface d'assemblage de la face (51) du troisième support (5) est formée avec les mêmes dimensions que la face arrière (21) de la puce (2).

9. Procédé selon l'une quelconque des revendications 1 à 6, dans lequel la face avant (22) de la puce (2) et la surface d'assemblage (411) de la face (41) du deuxième support (4) sont hydrophiles, et dans lequel la surface d'assemblage (411) de la face (41) du deuxième support (4) est entourée d'une surface hydrophobe.

10. Procédé selon l'une quelconque des revendications précédentes, dans lequel le premier support (1) est une tête de collecte et de placement de puces, et dans lequel la désolidarisation comprend une désactivation d'un système de maintien de la puce sur la tête de collecte et de placement.

11. Procédé selon la revendication 10, dans lequel la formation de la couche intercalaire (3), comprend successivement :
- une collecte de la puce (2), par une face arrière (21) opposée à la face avant (22), par la tête de collecte et de placement (210) depuis un support initial (7) de la puce, la collecte comprenant une activation du système de maintien de la puce (2);
- un premier déplacement de la tête de collecte et de placement jusqu'à un outil de dépôt de goutte (400);
- une formation d'une goutte, destinée à former la couche intercalaire (3), sur la face avant (22) de la puce (2) au moyen de l'outil de dépôt de goutte (400);
- un deuxième déplacement de la tête de collecte et de placement jusqu'au deuxième support (4), configuré pour que la goutte entre en contact avec la face (41) du support (4).

12. Procédé selon la revendication 11, comprenant une répétition du transfert en utilisant la tête de collecte et de placement de manière successive, pour une pluralité de puces, de sorte à placer la pluralité de puces (2) sur la face (41) du deuxième support (4).

13. Procédé selon l'une quelconque des revendications 1 à 9, dans lequel la désolidarisation comprend un déplacement relatif du premier support (1) et du deuxième support (4) configuré pour rompre une liaison mécanique entre le premier support (1) et la puce (2).

14. Procédé selon la revendication 13, comprenant, avant la formation d'une couche intercalaire (3) :
- alors que la puce (2) est contenue dans toute l'épaisseur d'une couche superficielle (13) du premier support (1) , un enlèvement d'une portion de la couche superficielle (13) configuré pour détourer la puce (2) tout en préservant au moins une zone d'ancrage (16) entre la puce (2) et la couche superficielle (13),
- puis, un enlèvement d'une portion d'une couche sous-jacente (12) à la couche superficielle (13), configuré pour libérer une face arrière (21) de la puce (2), opposée à la face avant (22), de sorte à suspendre la puce (2) par l'au moins une zone d'ancrage (16) formant la liaison mécanique.

15. Procédé selon l'une quelconque des deux revendications précédentes, dans lequel la formation de la couche intercalaire (3) comprend une phase de condensation, sur la face avant (22) de la puce (2), d'un composé d'une atmosphère dans laquelle sont placés le premier support (1) et le deuxième support (4).

## Patentansprüche

1. Verfahren zum Transferieren von mindestens einem Chip (2) von einem ersten Träger (1) ausgehend auf einen zweiten Träger (4), umfassend:
- während der Chip (2) mit dem ersten Träger (1) fest verbunden ist, eine Bildung einer Zwischenschicht (3) in flüssigem Zustand zwischen, und in Kontakt mit, einer Vorderfläche (22) des Chips (2) und einer Montageoberfläche (411) einer Fläche (41) des zweiten Trägers (4), und eine Verfestigung der Zwischenschicht (3),
- und dann, eine Verbindungsaufhebung des Chips (2), in Bezug auf den ersten Träger (1), unter Beibehaltung der Zwischenschicht (3) im festen Zustand, und
wobei die Verfestigung die Platzierung der Montageoberfläche (411) der Fläche (41) des zweiten Trägers (4) bei einer Temperatur unterhalb einer Verfestigungstemperatur der Zwischenschicht (3) umfasst, und **dadurch gekennzeichnet ist, dass** die Bildung der Zwischenschicht (3) eine Bildung einer flüssigen Beschichtung umfasst, die dazu bestimmt ist, eine Zwischenschicht (3) auf der Vorderfläche (22) des Chips (2) zu bilden, und dann, eine Annäherung des ersten Trägers (1) und des zweiten Trägers (4), um die flüssige Beschichtung und die Montageoberfläche (411) der Fläche (41) des zweiten Trägers (4) in Kontakt zu bringen, und
die Platzierung der Montageoberfläche (411) der Fläche (41) des zweiten Trägers (4), bei einer Temperatur unterhalb einer Verfestigungstemperatur der Zwischenschicht (3), vor der Kontaktbildung der flüssigen Beschichtung mit der Montageoberfläche (411) der Fläche (41) des zweiten Trägers (4) erfolgt.

2. Verfahren nach Anspruch 1, nach der Verbindungsaufhebung umfassend, eine Eliminierung der Zwischenschicht (3) und ein direktes Verkleben der Vorderfläche (22) des Chips (2) mit der Montageoberfläche (411) der Fläche (41) des zweiten Trägers (4).

3. Verfahren nach Anspruch 2, wobei die Eliminierung der Zwischenschicht (3) eine Verdampfung der Zwischenschicht (3) umfasst.

4. Verfahren nach einem der Ansprüche 1 bis 3, wobei die Montageoberfläche (411) der Fläche (41) des zweiten Trägers (4) mit den gleichen Abmessungen wie die Vorderfläche (22) des Chips (2) gebildet wird.

5. Verfahren nach einem der Ansprüche 1 bis 4, ferner umfassend, nach der Verbindungsaufhebung, ein festes Verbinden einer der Vorderfläche (22) gegenüberliegenden Hinterfläche (21) des Chips (2) mit einer Fläche (51) eines dritten Trägers (5), und dann, eine Trennung der Vorderfläche (22) des Chips (2) und der Montageoberfläche (411) der Fläche (41) des zweiten Trägers (4).

6. Verfahren nach Anspruch 1, ferner umfassend, nach der Verbindungsaufhebung, ein festes Verbinden einer der Vorderfläche (22) gegenüberliegenden Hinterfläche (21) des Chips (2) mit einer Fläche (51) eines dritten Trägers (5), und dann, eine Trennung der Vorderfläche (22) des Chips (2) und der Montageoberfläche (411) der Fläche (41) des zweiten Trägers (4), wobei bei diesem Verfahren die Zwischenschicht (3) in den flüssigen Zustand vor der Trennung der Vorderfläche (22) und des Chips (2) zurückversetzt wird.

7. Verfahren nach einem der zwei vorhergehenden Ansprüche, wobei die Vorderfläche (22) des Chips (2) und die Montageoberfläche (411) der Fläche (41) des zweiten Trägers (4) hydrophob sind und wobei das feste Verbinden der Hinterfläche (21) des Chips (2) umfasst:
- Bildung einer zweiten Zwischenschicht (6) in flüssigem Zustand zwischen, und in Kontakt mit, der Hinterfläche (21) des Chips (2) und einer Montageoberfläche der Fläche (51) des dritten Trägers (5), wobei die Hinterfläche (21) des Chips (2) und die Montageoberfläche der Fläche (51) des dritten Trägers (5) hydrophil sind, und dann,
- während die Zwischenschicht (3) und die zweite Zwischenschicht (6) in flüssigem Zustand sind, die Trennung der Vorderfläche (22) des Chips (2) und der Montageoberfläche (411) der Fläche (41) des zweiten Trägers (4), eine relative Verschiebung des zweiten Trägers (4) und des dritten Trägers (5) umfassend.

8. Verfahren nach dem vorhergehenden Anspruch, wobei die Montageoberfläche der Fläche (51) des dritten Trägers (5) mit den gleichen Abmessungen wie die Hinterfläche (21) des Chips (2) gebildet wird.

9. Verfahren nach einem der Ansprüche 1 bis 6, wobei die Vorderfläche (22) des Chips (2) und die Montageoberfläche (411) der Fläche (41) des zweiten Trägers (4) hydrophil sind, und wobei die Montageoberfläche (411) der Fläche (41) des zweiten Trägers (4) von einer hydrophoben Oberfläche umgeben ist.

10. Verfahren nach einem der vorhergehenden Ansprüche, wobei der erste Träger (1) ein Sammel- und Platzierungskopf eines Chips ist, und wobei die Verbindungsaufhebung eine Deaktivierung eines Haltesystems des Chips auf dem Sammel- und Platzierungskopf umfasst.

11. Verfahren nach Anspruch 10, wobei die Bildung der Zwischenschicht (3) aufeinanderfolgend umfasst:
- ein Sammeln des Chips (2), durch eine der Vorderfläche (22) gegenüberliegende Hinterfläche (21), durch den Sammel- und Platzierungskopf (210), von einem Anfangsträger (7) des Chips ausgehend, wobei das Sammeln eine Aktivierung des Haltesystems des Chips (2) umfasst;
- eine erste Verschiebung des Sammel- und Platzierungskopfs bis zu einem Tropfenabscheidewerkzeug (400);
- eine Bildung eines Tropfens, dazu bestimmt, die Zwischenschicht (3) auf der Vorderfläche (22) des Chips (2) mittels des Tropfenabscheidewerkzeugs (400) zu bilden;
- eine zweite Verschiebung des Sammel- und Platzierungskopfs bis zum zweiten Träger (4), so konfiguriert, dass der Tropfen mit der Fläche (41) des Trägers (4) in Kontakt kommt.

12. Verfahren nach Anspruch 11, eine Wiederholung der Transferierung unter Verwendung des Sammel- und Platzierungskopfs aufeinanderfolgend für eine Vielzahl von Chips umfassend, um die Vielzahl von Chips (2) auf der Fläche (41) des zweiten Trägers (4) zu platzieren.

13. Verfahren nach einem der Ansprüche 1 bis 9, wobei die Verbindungsaufhebung eine relative Verschiebung des ersten Trägers (1) und des zweiten Trägers (4) umfasst, konfiguriert, um eine mechanische Verbindung zwischen dem ersten Träger (1) und dem Chip (2) aufzubrechen.

14. Verfahren nach Anspruch 13, umfassend, vor der Bildung einer Zwischenschicht (3):
- während der Chip (2) in der gesamten Dicke einer Oberflächenschicht (13) des ersten Trägers (1) enthalten ist, eine Entfernung eines Abschnitts der Oberflächenschicht (13), konfiguriert, um den Chip (2) zu beschneiden, wobei mindestens eine Verankerungszone (16) zwischen dem Chip (2) und der Oberflächenschicht (13) erhalten bleibt,
- und dann, eine Entfernung eines Abschnitts einer unter der Oberflächenschicht (13) liegenden Schicht (12), konfiguriert, um eine der Vorderfläche (22) gegenüberliegende Hinterfläche (21) des Chips (2) freizugeben, so dass der Chip (2) durch die mindestens eine Verankerungszone (16), die die mechanische Verbindung bildet, aufgehängt wird.

15. Verfahren nach einem der zwei vorhergehenden Ansprüche, wobei die Bildung der Zwischenschicht (3) eine Kondensationsphase auf der Vorderfläche (22) des Chips (2) einer Mischung aus einer Atmosphäre umfasst, in der der erste Träger (1) und der zweite Träger (4) angeordnet sind.

## Claims

1. A method for transferring at least one chip (2), from a first support (1) to a second support (4), comprising:
- while the chip (2) is integral with the first support (1), a formation of an intermediate layer (3) in the liquid state between, and in contact with, a front face (22) of the chip (2) and an assembly surface (411) of a face (41) of the second support (4), and a solidification of the intermediate layer (3)
- then, a detachment of the chip (2) from the first support (1) while maintaining the intermediate layer (3) in the solid state, and
wherein the solidification comprises placing the assembly surface (411) of the face (41) of the second support (4) at a temperature lower than a solidification temperature of the intermediate layer (3), and **characterised in that** the formation of the intermediate layer (3) comprises forming a liquid coating intended to form the intermediate layer (3) on the front face (22) of the chip (2), then bringing together the first support (1) and the second support (4) so as to contact the liquid coating with the assembly surface (411) of the face (41) of the second support (4), and
placing the assembly surface (411) of the face (41) of the second support (4) at a temperature lower than a solidification temperature of the intermediate layer (3) is carried out before contacting the liquid coating with the assembly surface (411) of the face (41) of the second support (4).

2. The method according to claim 1, comprising after detachment, eliminating the intermediate layer (3), and directly bonding the front face (22) of the chip (2) on the assembly surface (411) of the face (41) of the second support (4).

3. The method according to claim 2, wherein the elimination of the intermediate layer (3) comprises evaporating the intermediate layer (3).

4. The method according to any one of claims 1 to 3, wherein the assembly surface (411) of the face (41) of the second support (4) is formed with the same dimensions as the front face (22) of the chip (2).

5. The method according to any one of claims 1 to 4, further comprising, after detachment, securing a rear face (21), opposite the front face (22), of the chip (2) on a face (51) of a third support (5), then separating the front face (22) of the chip (2) and the assembly surface (411) of the face (41) of the second support (4).

6. The method according to claim 1, further comprising, after detachment, securing a rear face (21), opposite to the front face (22), of the chip (2) on a face (51) of a third support (5), then separating the front face (22) of the chip (2) and the assembly surface (411) of the face (41) of the second support (4), a method wherein the intermediate layer (3) is returned to the liquid state before the separation of the front face (22) of the chip (2).

7. The method according to any one of the two preceding claims, wherein the front face (22) of the chip (2) and the assembly surface (411) of the face (41) of the second support (4) are hydrophobic, and wherein the securing of the rear face (21) of the chip (2) comprises:
- a formation of a second intermediate layer (6) in the liquid state between, and in contact with, the rear face (21) of the chip (2) and an assembly surface of the face (51) of the third support (5), the rear face (21) of the chip (2) and the assembly surface of the face (51) of the third support (5) being hydrophilic, then,
- while the intermediate layer (3) and the second intermediate layer (6) are in the liquid state, the separation of the front face (22) of the chip (2) and the assembly surface (411) of the face (41) of the second support (4) comprising a relative movement of the second support (4) and the third support (5).

8. The method according to the preceding claim, wherein the assembly surface of the face (51) of the third support (5) is formed with the same dimensions as the rear face (21) of the chip (2).

9. The method according to any one of claims 1 to 6, wherein the front face (22) of the chip (2) and the assembly surface (411) of the face (41) of the second support (4) are hydrophilic, and wherein the assembly surface (411) of the face (41) of the second support (4) is surrounded by a hydrophobic surface.

10. The method according to any one of the preceding claims, wherein the first support (1) is a chip collection and placement head, and wherein the detachment comprises deactivating a system for holding the chip on the collection and placement head.

11. The method according to claim 10, wherein the formation of the intermediate layer (3) successively comprises:
- a collection of the chip (2), by a rear face (21) opposite the front face (22), by the collection and placement head (210) from an initial support (7) of the chip, the collection comprising an activation of the chip holding system (2);
- a first movement of the collection and placement head to a drop depositing tool (400);
- a formation of a drop, intended to form the intermediate layer (3), on the front face (22) of the chip (2) by means of the drop depositing tool (400);
- a second movement of the collection and placement head to the second support (4), configured so that the drop contacts the face (41) of the support (4).

12. The method according to claim 11, comprising repeating the transfer using the collection and placement head in succession, for a plurality of chips, so as to place the plurality of chips (2) on the face (41) of the second support (4).

13. The method according to any one of claims 1 to 9, wherein the detachment comprises a relative movement of the first support (1) and the second support (4) configured to break a mechanical connection between the first support (1) and the chip (2).

14. The method according to claim 13, comprising, before the formation of an intermediate layer (3):
- while the chip (2) is contained in the entire thickness of a surface layer (13) of the first support (1), a removal of a portion of the surface layer (13) configured to trim the chip (2) while preserving at least one anchoring zone (16) between the chip (2) and the surface layer (13),
- then, a removal of a portion of a layer (12) underlying the surface layer (13), configured to release a rear face (21) of the chip (2), opposite the front face (22), so as to suspend the chip (2) by the at least one anchoring zone (16) forming the mechanical connection.

15. The method according to any one of the two preceding claims, wherein the formation of the intermediate layer (3) comprises a phase of condensation, on the front face (22) of the chip (2), of a compound of an atmosphere wherein the first support (1) and the second support (4) are placed.
